Europäisches Patentamt

European Patent Office

Office européen des brevets

(11) Publication number: **0 409 623 A1**

# EUROPEAN PATENT APPLICATION

(21) Application number: 90307908.5

(22) Date of filing: 19.07.90

(51) Int. Cl.5: **C09J 167/06**, //(C09J167/06, 163:10),(C09J167/06,133:14)

(30) Priority: 19.07.89 JP 188420/89

(43) Date of publication of application:
23.01.91 Bulletin 91/04

(84) Designated Contracting States:
**BE DE ES FR GB IT NL**

(71) Applicant: SOMAR CORPORATION
11-2, Ginza 4-chome Chuo-ku
Tokyo 104(JP)

(72) Inventor: Morikubo, Kunio
Shinei-Danchi 3-2-207, 1000 Shinei-cho
Soka-shi, Saitama-ken(JP)
Inventor: Kawano, Takayuki
250-43 Fujitsuka
Kasukabe-shi, Saitama-ken(JP)
Inventor: Fujii, Ryuichi
33-8-10-206 Harayama 2-chome
Urawa-shi, Saitama-ken(JP)

(74) Representative: Allam, Peter Clerk et al
LLOYD WISE, TREGEAR & CO. Norman
House 105-109 Strandand
London WC2R 0AE(GB)

(54) Adhesive composition.

(57) An adhesive composition is discloses which includes a polymerizable substance, a reactive diluent and a polymerization initiator, wherein the polymerizable substance includes ingredient (a) which is an ethylenically unsaturated polyester resin and ingredient (b) which is at least one aromatic (meth)acrylate compound selected from (meth)acrylates of epoxy resins and aromatic (meth)acrylates of the following general formula:

$$CH_2 = CR^1 - CO \{O - R^2\}_n O - A - X - B (R^3 - O\}_m CO - CR^4 = CH_2$$

wherein $R^1$ and $R^4$ stand, independently from each other, hydrogen or a methyl group, $R^2$ and $R^3$ stand, independently from each other, a lower alkylene group, A and B stand, independently from each other, for a divalent aromatic group, X stands for a direct bond or a divalent group, and n and m, independently from each other, an integer of 0 or more.

## ADHESIVE COMPOSITION

This invention relates generally to an adhesive composition and, more specifically, to a photo- or heat-curable adhesive composition useful for bonding electric chip parts to printed wiring boards.

In mounting chip parts such as resistors and capacitors on a printed wiring board, it is a general practice to first bond such parts on the board with a suitable adhesive, the bonded parts being subsequently soldered to establish electrical connection between the contacts of the parts and the wiring of the board. Since the adhesive is subjected to high temperatures and abrupt thermal shock in the soldering stage, deterioration of the adhesion strength is apt to occur. This causes a problem that the bonded chip parts are displaced or separated from the board. Thus, it is highly desirous to provide an adhesive which withstands high temperatures. Additionally, adhesive compositions for use in the above purposes are desired to have a resistance to moisture and exhibit good electrical insulation even when exposed to moistened conditions. Known adhesive compositions, however, are not fully satisfactory with respect to the above properties.

The present invention has been made to provide an adhesive composition hardenable upon being heated or irradiated by actinic light to provide strong adhesion and excellent electrical insulation which properties are not deteriorated even when subjected to high soldering temperatures or even when exposed to high humidity conditions for a long period of time.

In accordance with the present invention there is provided an adhesive composition comprising a polymerizable substance, a reactive diluent and a polymerization initiator, characterized in that said polymerizable substance includes ingredients (a) and (b), said ingredient (a) being an ethylenically unsaturated polyester resin and said ingredient (b) being at least one aromatic (meth)acrylate compound selected from the group consisting of (meth)acrylates of epoxy resins and aromatic (meth)acrylates of the following general formula (I):

$$CH_2 = CR^1 - CO \{O - R^2\}_n O - A - X - B \{R^3 - O\}_m CO - CR^4 = CH_2 \quad (I)$$

wherein $R^1$ and $R^4$ stand, independently from each other, hydrogen or a methyl group, $R^2$ and $R^3$ stand, independently from each other, a lower alkylene group, A and B stand, independently from each other, for a divalent aromatic group, X stands for a direct bond or a divalent group, and n and m, independently from each other, an integer of 0 or more , preferably the amount of the ingredient (b) is 5-50 parts by weight per 100 parts by weight of a total weight of the ingredient (a) and the reactive diluent.

The present invention will now be described in detail below.

In the present specification and the appended claims, the term "(meth)acrylate" is intended to refer to an acrylate, a methacrylate and a mixture thereof.

The ingredient (a) constituting part of the polymerizable substance in the adhesive composition is an ethylenically unsaturated polyester resin. The polyester resin preferably has a molecular weight of 1,000 to 10,000 and may be obtained by reaction of an ethylenically unsaturated polybasic carboxylic acid, such as maleic anhydride, fumaric acid, itaconic acid, tetrahydroxyphthalic anhydride or methyltetrahydrophthalic anhydride with a glycol such as ethylene glycol, propylene glycol, diethylene glycol, neopentyl glycol or bisphenol A propionic acid adduct. The ethylenically unsaturated carboxylic acid may used in conjunction with an aromatic carboxylic acid such as phthalic anhydride, isophthalic acid or terephthalic acid.

The ingredient (b) of the polymerizable substance is an aromatic (meth)acrylate which is (b-1) a (meth)-acrylate of an epoxy resin, (b-2) a (meth)acrylate of the above formula (I), or (b-3) a mixture thereof.

The (meth)acrylate of an epoxy resin (b-1) is a product obtained by full esterification of an epoxy resin with (meth)acrylic acid and preferably has a molecular weight of 350-3,000, more preferably 480-2,000. The epoxy resin is preferably a glycidyl ether epoxy resin such as a bisphenol A epoxy resin, a bisphenol F epoxy resin, a brominated bisphenol A epoxy resin, a phenol novolak epoxy resin or a cresol novolak epoxy resin.

In the aromatic (meth)acrylate (b-2) of the formula (I), the group -A-X-B- is preferably as follows:
$-C_6H_4-C_6H_4-$, $-C_6H_4-CH_2-C_6H_4-$, $-C_6H_4-C(CH_3)_2-C_6H_4-$ and $-C_6H_4-SO_2-C_6H_4-$.

The lower alkylene group represented by $R^2$ or $R^3$ is preferably ethylene, trimethylene, propylene or butylene. In the case of ethylene, $m+n$ is preferably 2-30 . In the case of propylene, $m+n$ is preferably 2-4. Illustrative of suitable aromatic (meth)acrylates (b-2) are as follows:

Compound No. 1: $CH_2 = CCH_3 - CO - O - C_6H_4 - C(CH_3)_2 - C_6H_4 - O - CO - CCH_3 = CH_2$
Compound No. 2: $CH_2 = CCH_3 - CO - O - C_2H_4 - O - C_6H_4 - C(CH_3)_2 - C_6H_4 - O - C_2H_4 - O - CO - CCH_3 = CH_2$
Compound No. 3: $CH_2 = CH - CO - O - C_2H_4 - O - C_6H_4 - SO_2 - C_6H_4 - O - C_2H_4 - O - CO - CH = CH_2$
Compound No. 4: $CH_2 = CH - CO\{OC_2H_4\}_n O - C_6H_4 - C(CH_3)_2 - C_6H_4 - O\{C_2H_4O\}_m CO - CH = CH_2$ ($n+m$ = about 10)

2

Compound No. 5: $CH_2 = CHCO\{OCH(CH_3)-CH_2\}_2OC_6H_4-C(CH_3)_2-C_6H_4O\{CH_2-CHCH_3O\}_2COCH = CH_2$

The polymerizable substance may additionally contain, as an optional ingredient (c), an urethane (meth)acrylate and/or an oligoester (meth)acrylate. The urethane (meth)acrylate is a product obtained by reacting a hydroxyalkyl(meth)acrylate with a terminal isocyanate group-containing urethane compound which is obtainable by reacting an aliphatic diol (e.g. ethylene glycol) or an ether diol having two hydroxyl group at both terminal ends (e.g. poly(ethylene glycol) with a stoicheometrically excess amount of a diisocyanate such as toluenediisocyanate or isophoronediisocyanate. Such urethane (meth)acrylates are commercially available as, for example, UBISAN 893 (manufactured by Thiocole Inc.) and U-6HA (manufactured by Shin-Nakamura Kagaku K. K.). The oligoester (meth)acrylate is a polyfunctional (meth)-acrylate having an ester skeleton obtained from an aromatic carboxylic acid and is commercially available as ARONIX M-8060 and ARONIX M-7100 (both manufactured by Toa Gosei Kagaku Kogyo K. K.). An example of such oligoester is an isophthalic acid ester derivative of the formula:

$CH_2 = CH-CO-(OCH_2CH_2)_3-O-CO-(CH_2)_4-CO-O-CH_2CH_2-O-CO-C_6H_4-CO-O-CH_2CH_2CH(CH_3)-O-CO-CH = CH_2$

The above polymerizable substance is used in combination with a reactive diluent which serves to adjust the viscosity of the adhesive composition and the properties of cured adhesive layers obtained therefrom. The reactive diluent is suitably a mono or polyfunctional (meth)acrylate containing no aromatic groups. Examples of such polyfunctional (meth)acrylates include trimethylolpropane tri(meth)acrylate, pentaerythritol tetra-(meth)acrylate, dipentaerythritol hexa(meth)acrylate, 1,6 hexanediol di(meth)acrylate, triethylene glycol di(meth)acrylate, neopentyl glycol di(meth)acrylate, polyethylene glycol di(meth)acrylate, hydroxypivalic acid neopentylglycol di(meth)acrylate and dibasic aliphatic acid diglycidyl ester di(meth)-acrylates. The polyfunctional (meth)acrylates are commercially available as BISCOAT #3700, BISCOAT #700 (both manufactured by Osaka Yuki K. K.), ARONIX M610, ARONIX M6300 (both manufactured by Toa Gosei Kagaku Kogyo K. K), MONOSIZER TD-1600 (manufactured by Dainihon Ink K. K.) and ULB-20GEA (manufactured by Okamura Seiyu K. K.). Illustrative of monofunctional (meth)acrylate are hydroxyethyl (meth)acrylate, tetrahydrofurfuryl (meth)acrylate, phenoxyethyl (meth)acrylate and dicyclopentenyl (meth)-acrylate.

In the adhesive composition according to the present invention, the weight ratio of the polymerizable substance to the reactive diluent is generally in the range of 10:90 to 80:20, preferably 20:80 to 70:30. It is desirable that the ingredient (b) should be used in an amount of 5-50 parts by weight per 100 parts by weight of a total weight of the ingredient (a) and the reactive diluent. An amount of thc ingredient (b) below the above-specified range can cause reduction of moisture resistance of the cured adhesive composition so that the electrical insulation thereof becomes poor when enclosed to a highly humid environment. On the other hand, too large an amount of the ingredient (b) in excess of the above-specified range can cause a high curing stress so that the adhesion strength becomes poor. The amount of the ingredient (b) is most preferably 10-40 parts by weight per 100 parts by weight of the total weight of the ingredient (a) and the reactive diluent. Preferably, when the polymerizable substance contains the ingredient (c) in addition to ingredients (a) and (b), the amount of the ingredient (c) is 5-50 parts by weight, preferably 10-30 parts by weight per 100 parts by weight of the total of the ingredient (a), the ingredient (b) and the reactive diluent.

The polymerization initiator to be used in the present invention is a photopolymerization initiator, such as a benzoin ether compound, a benzophenone compound, an acetophenone compound or a thioxanthone compound, and/or a thermal polymerization initiator, such as a peroxide compound. The initiator is generally used in an amount of 0.2-20 parts by weight per 100 parts by weight of the total of the polymerizable substance and the reactive diluent.

Illustrative of suitable photopolymerization initiators are benzoin isopropyl ether, benzoin isobutyl ether, benzophenone, 2,2-dimethoxy-2-phenylacetophenone, 1-hydroxycyclohexyl phenyl ketone, p-isopropyl-α-hydroxyisobutylphenone, α-hydroxyisobutylphenone, 1,1-dichloroacetophenone, 2-chlorothioxanthone, 2-methylthioxanthone and methylbenzoyl formate. These initiators may be used by themselves or as a mixture of two or more.

Examples of suitable thermal polymerization initiators include ketone peroxides such as methyl ethyl ketone peroxide and cyclohexanone peroxide; diacyl peroxides such as acetyl peroxide and benzoyl peroxide; hydroperoxides such as t-butyl hydroperoxide and cumene hydroperoxide; dialkylperoxides such as di-t-butyl peroxide and dicumyl peroxide; dialkyl peresters such as t-butyl peracetate, t-butyl perbenzoate; peroxycarbonates such as diisopropyl peroxydicarbonate and bis(4-t-butylcyclohexyl)-peroxydicarbonate; and peroxy ketals such as 1,1-bis(t-butylperoxy)-3,3,5-trimethylcyclohexane and 1,1-bis-(t-butylperoxy)cyclohexane. These initiators may be used by themselves or as a mixture of two or more.

The adhesive composition preferably contains an inorganic filler such as silica, talc, alumina, zirconia, barium sulfate, calcium silicate, zeolite, kaolin, sericite or basic magnesium carbonate. The use of an inorganic filler with an average particle size of 0.5-50 $\mu$m, particularly 1.5-20 $\mu$m is advisable. Both spherical and flake-like fillers may be used and the conjoint use of these fillers is preferred. Examples of spherical fillers include spherical fused silica, glass beads, granular alumina, silica balloons and synthetic calcium silicate. The flake-like fillers include, for example, talc, calcium silicate, zeolite, kaolin, calcined clay, bentonite, sericite and basic magnesium carbonate. Above all, the conjoint use of spherical fused silica or glass bead as a spherical filler component and talc as a flake-like filler component is particularly preferred.

The inorganic filler is generally used in an amount of 30-200 parts by weight, preferably 60-150 parts by weight per 100 parts by weight of the total of the polymerizable substance and the reactive diluent. When a combination of a spherical filler with a flake-like filler is used, the former and the latter fillers are preferably used in amounts of 10-50 parts by weight and 50-150 parts by weight per 100 parts by weight of the total amount of the polymerizable substance and the reactive diluent.

The adhesive composition according to the present invention may additionally contain one or more customarily used additives such as a chelate agent, a thermal polymerization inhibitor, a colorant, a thixotropic agent and a curing accelerator.

Examples of chelate agents include iminodiacetic acid, N-methyliminodiacetic acid, nitrilotriacetic acid, ethylenediamine-N,N$'$-diacetic acid, ethylenediamine-N,N,N$'$,N$'$-tetraacetic acid, N-2-hydroxyethylethylenediamine-N,N$'$,N$'$-triacetic acid, sodium salts of the above acids, and N,N,N$'$,N$'$-tetrakis-(2-hydroxypropyl)ethylenediamine. Examples of thermal polymerization inhibitors include hydroquinone, p-methoxyphenol, benzoquinone, phenothiazine and cupferron, Examples of colorants include azo dyes, phthalocyanine dyes, isoindolinone dyes, anthraquinone dyes and carbon black. Illustrative of thixotropic agents are bentonite and finely divided anhydrous silica. Curing accelerators may include metal salts of long chain organic acids such as cobalt naphthenate and cobalt octenate; amines such as dimethylaniline, N-phenylmorphorine; quarternary ammonium slats such as tiethylbenzylammonium chloride; and aminophenols such as 2,4,6-tris(dimethylaminomethyl)phenol.

The adhesive composition may be prepared in any known manner. For example, a polymerizable substance, a reactive diluent, a photopolymerization initiator, a polymerization inhibitor, a chelating agent, etc are mixed to form a homogeneous liquid into which a thixotropic agent, an inorganic filler, a colorant, etc. are dispersed. Then, the resulting dispersion is mixed with a thermal polymerization initiator using a stirrer or a roll mixer at 60 $^\circ$C or less to thereby obtain a desired adhesive. The adhesive composition is suitably utilized for bonding various articles and especially suitably used for mounting electric or electronic chip parts on printed wiring boards.

The following examples will further illustrate the present invention. In the examples, "part" is by weight. Test methods employed in the examples are as follows:

Initial Insulation Resistance:

In accordance with Insulation Resistance Test as specified in JIS Z3197 (1986), a sample adhesive is applied on a specified comb-like electrode to a thickness of 200 $\mu$m and the coating is irradiated with UV rays using a 80 W/cm high pressure mercury lamp at a distance of 20 cm for about 20 seconds. The resulting coating is immediately heated at 150 $^\circ$C for 2 minutes in a hot chamber and then allowed to be cooled to room temperature. The cured coating is measured for its insulation resistance using an insulation resistance tester (manufactured by Takeda Riken Inc.) 1 minute after application of a direct current of 100 V.

Insulation Resistance after Exposure to Moisture Test :

In the same manner as in the above test, a comb-like electrode is coated with a sample adhesive and cured. The coated electrode is placed in a constant temperature/humidity chamber and maintained at a temperature of 40 $^\circ$C ± 2 $^\circ$C and a relative humidity of 90-95 % for 72 hours. The resulting coat is measured for its insulation resistance in the same manner as above.

Initial Adhesion Strength :

A sample adhesive (about 0.4 mg) is applied to a printed wiring board and a chip part (3.2 mm x 1.6 mm ceramic capacitor) is placed on the center of the adhesive layer. This is then irradiated with UV rays using a 80 W/cm high pressure mercury lamp at a distance of 20 cm for about 20 seconds and, thereafter, immediately heated at 120 °C for 10 minutes. The shear adhesion strength between the board and the chip part is then measured.

Adhesion Strength after Immersion in Solder Bath :

In the same manner as in the above test, a chip part is bonded to a board. The board is immersed in a solder bath at 260 °C for 10 seconds and is then cooled to room temperature. Such an immersion and cooling step is repeated 6 times in total. Thereafter, the shear adhesion strength is measured.

Example 1

A homogeneous mixture (Z-1) consisting of 37 parts of unsaturated polyester resin (molecular weight: about 2,500, YUPICA 8544 manufactured by Nihon Yupica K. K.), 26 parts of a reactive diluent (acrylic acid ester of glycidyl ester of unsaturated aliphatic dicarboxylic acid ULB-20GEA manufactured by Okamura Seiyu K. K.) and 37 parts of tetrahydrofurfuryl methacrylate (reactive diluent) was prepared. To 100 parts of the above mixture (Z-1) were then added the ingredients shown in Table 1 and the resulting blend was mixed at a temperature of below 40 °C to obtain Adhesive Nos. 1-7. These adhesives were tested for their moisture and solder resistance in the manner described above. The results are also summarized in Table 1.

In Table 1, the ingredients are as follows:

Acrylate I: Diacrylate of diglycidyl ether of bisphenol A (molecular weight: about 640, SP-1509 manufactured by Showa Kobunshi K. K.)

Acrylate II: Diacrylate of diglycidyl ether of bisphenol A (molecular weight: about 900, SP-1563 manufactured by Showa Kobunshi K. K.)

Acrylate III: Diacrylate of glycidyl ether of phenol novolak eposy resin (molecular weight: about 2,000, SP-4010 manufactured by Showa Kobunshi K. K.)

Photo Initiator: $C_6H_5$-CO-C$(OCH_3)_2$-C$_6H_5$ (photopolymerization initiator IRUGACURE 651 manufactured by Ciba-Geigy Inc.)

Thermal Initiator: 1,1-Di-t-butylperoxide-3,3,5-trimethylcylohexane (thermal polymerization initiator TRIGONOX 22-B75 manufactured by Kayaku-Aczo Inc.)

Inhibitor: p-Methoxyphenol (polymerization inhibitor)

Chelate Agent: N,N,N',N'-Tetraethylenediaminetetraacetic acid tetrasodium salt

Flake-like Filler: Talc (average diameter: 3.0 μm, LMR-100 manufactured by Fuji Talc K. K.)

Spherical Filler: Silica (average diameter: 10.0 μm, FB-44 manufactured by Denki Kagaku Kogyo K. K.)

Table 1

| Adhesive No. | 1 | 2 | 3 | 4 | 5* | 6* | 7* |
|---|---|---|---|---|---|---|---|
| Ingredients | | | | | | | |
| Mixture Z-1 | 100 | 100 | 100 | 100 | 100 | 100 | 100 |
| Acrylate I | 30 | | | | 15 | 60 | |
| Acrylate II | | 20 | | | | | |
| Acrylate III | | | 40 | 20 | | | 80 |
| Photo Initiator | 3 | 3 | 3 | 3 | 3 | 3 | 3 |
| Thermal Initiator | 3 | 3 | 3 | 3 | 3 | 3 | 3 |
| Inhibitor | 0.1 | 0.1 | 0.1 | 0.1 | 0.1 | 0.1 | 0.1 |
| Chelate Agent | 0.1 | 0.1 | 0.1 | 0.1 | 0.1 | 0.1 | 0.1 |
| Flake-like Filler | 80 | 80 | 80 | 80 | 80 | 80 | 80 |
| Spherical Filler | 20 | 20 | 20 | 20 | 20 | 20 | 20 |
| Characteristics | | | | | | | |
| Initial Resistance ($\Omega$) | $>10^{14}$ | $>10^{14}$ | $>10^{14}$ | $>10^{14}$ | $>10^{14}$ | $>10^{14}$ | $>10^{14}$ |
| Resistance after Moisture Test ($\Omega$) | $2.5 \times 10^{11}$ | $1.2 \times 10^{11}$ | $2.1 \times 10^{11}$ | $3.5 \times 10^{11}$ | $1.2 \times 10^{8}$ | $1.0 \times 10^{11}$ | $1.3 \times 10^{11}$ |
| Initial Strength (kg) | 4.6 | 4.8 | 4.5 | 5.0 | 3.8 | 3.2 | 2.0 |
| Strength after Solder Test (kg) | 4.5 | 4.6 | 4.4 | 4.8 | 3.6 | 1.2 | 1.1 |

*: Comparative adhesive composition

Example 2

A homogeneous mixture (Z-2) consisting of 25 parts of unsaturated polyester resin (molecular weight: about 2,000, NEWTRUCK 410S manufactured by Kao Inc.), 20 parts of a reactive diluent (ULB-20GEA manufactured by Okamura Seiyu K. K.), 15 parts of tris(acryloxyethyl)isocyanurate (reactive diluent) and 40 parts of tetrahydrofurfuryl methacrylate (reactive diluent) was prepared. To 100 parts of the above mixture (Z-2) were then added the ingredients shown in Table 2 and the resulting blend was mixed at a temperature of below 40 °C to obtain Adhesive Nos. 8-11. These adhesives were tested for their moisture and solder resistance in the manner described above. The results are also summarized in Table 2.

In Table 2, the ingredients are as follows:

Acrylate IV: Aromatic acrylate, Compound No. 4 previously mentioned (NK ESTER A-BPE-10 manufactured by Shin Nakamura Kogyo K. K.)

Acrylate V: Aromatic acrylate, Compound No. 5 previously mentioned (LIGHT ESTER BP-4PA manufactured by Kyoeisha Yushi Kagaku Kogyo K. K.)

Acrylate VI: Aromatic acrylate, Compound No. 3 previously mentioned (ARONIX M-205 manufactured by Toa Gosei Kagaku Kogyo K. K.)

Photo Initiator: IRUGACURE 651 manufactured by Ciba-Geigy Inc.)

Thermal Initiator: TRIGONOX 22-B75 manufactured by Kayaku-Aczo Inc.)

Inhibitor: N,Nitrosophenylhydroxylamine ammonium salt (polymerization inhibitor CUPHERRON Q-1300 manufactured by Wako Junyaku Kogyo K. K.)

Chelate Agent: N,N,N′,N′-Tetraethylenediaminetetraacetic acid tetrasodium salt

Flake-like Filler: Talc (average diameter: 3 $\mu$m, HYTORON A manufactured by Takehara Kagaku K. K.)

6

EP 0 409 623 A1

Table 2

| Adhesive No. | 8 | 9 | 10 | 11* |
|---|---|---|---|---|
| Ingredients | | | | |
| Mixture Z-2 | 100 | 100 | 100 | 100 |
| Acrylate IV | 15 | | | |
| Acrylate V | | 10 | | |
| Acrylate VI | | | 20 | 3 |
| Photo Initiator | 3 | 3 | 3 | 3 |
| Thermal Initiator | 3 | 3 | 3 | 3 |
| Inhibitor | 0.05 | 0.05 | 0.05 | 0.05 |
| Chelate Agent | 0.1 | 0.1 | 0.1 | 0.1 |
| Flake-like Filler | 100 | 100 | 100 | 100 |
| Characteristics | | | | |
| Initial Resistance ($\Omega$) | $>10^{14}$ | $>10^{14}$ | $>10^{14}$ | $>10^{14}$ |
| Resistance after Moisture Test ($\Omega$) | $5.5\times10^{11}$ | $2.0\times10^{11}$ | $3.2\times10^{11}$ | $1.2\times10^{8}$ |
| Initial Strength (kg) | 3.5 | 4.2 | 3.8 | 3.2 |
| Strength after Solder Test (kg) | 3.3 | 3.9 | 3.6 | 2.9 |

*: Comparative adhesive composition

## Claims

1. An adhesive composition comprising a polymerizable substance, a reactive diluent and a polymerization initiator, characterized in that said polymerizable substance includes ingredients (a) and (b), said ingredient (a) being an ethylenically unsaturated polyester resin and said ingredient (b) being at least one aromatic (meth)acrylate compound selected from the group consisting of (meth)acrylates of epoxy resins and aromatic (meth)acrylates of the following general formula:

$$CH_2 = CR^1 - CO \{O - R^2\}_n O - A - X - B \{R^3 - O\}_n CO - CR^4 = CH_2$$

wherein $R^1$ and $R^4$ stand, independently from each other, hydrogen or a methyl group, $R^2$ and $R^3$ stand, independently from each other, a lower alkylene group, A and B stand, independently from each other, for a divalent aromatic group, X stands for a direct bond or a divalent group, and n and m, independently from each other, an integer of 0 or more.

2. A composition as claimed in claim 1, wherein said (meth)acrylates of epoxy resins are (meth)acrylic acid esters of glycidyl ethers of aromatic epoxy resins.

3. A composition as claimed in claim 1, wherein $R^2$ and $R^3$ each represent ethylene or propylene, A and B each represent phenylene, X represents a direct bond, methylene, sulfonyl or isopropylidene, and m and n are integers with the proviso that when $R^2$ and $R^3$ are each ethylene, $m+n$ is 2-30 and that when $R^2$ and $R^3$ are each propylene, $m+n$ is 2-4.

4. A composition as claimed in claim 1, wherein said reactive diluent is a member selected from the group consisting of trimethylolpropane tri(meth)acrylate, pentaerythritol tetra(meth)acrylate, dipentaerythritol hexa-(meth)acrylate, 1,6-hexanediol di(meth)acrylate, triethylene glycol di(meth)acrylate, neopentyl glycol di-(meth)acrylate, polyethylene glycol di(meth)acrylate, hydroxypivalic acid neopentylglycol di(meth)acrylate, dibasic resin acid diglycidyl ester di(meth)acrylates, hydroxyethyl (meth)acrylate, tetrahydrofurfuryl (meth)-acrylate, phenoxyethyl (meth)acrylate, and dicyclopentnyl (meth)acrylate.

5. A composition as claimed in claim 1, wherein said polymerizable substance further includes an urethane meth(acrylate) or an oligoester (meth)acrylate.

6. A composition as claimed in claim 1, wherein the ingredient (b) is used in an amount of 5-50 parts by weight per 100 parts by weight of a total weight of the ingredient (a) and the reactive diluent.

7. A composition as claimed in claim 1, wherein the weight ratio of the polymerizable substance to the reactive diluent is in the range of 10:90 to 80:20.

7

## DOCUMENTS CONSIDERED TO BE RELEVANT

EP 90307908.5

| Category | Citation of document with indication, where appropriate, of relevant passages | Relevant to claim | CLASSIFICATION OF THE APPLICATION (Int. Cl.5) |
|---|---|---|---|
| A | US - A - 4 814 365 (TAKIYAMA et al.) * Claims 1,4-7; column 7, line 66 - column 8, line 8; abstract * | 1-5 | C 09 J 167/06 //(C 09 J 167/06 C 09 J 163:10) (C 09 J 167/06 C 09 J 133:14) |
| A | EP - A2 - 0 313 071 (NICHIBAN CO. LTD.) * Claims 1,3,4,7-10 * | 1,4,5 7 | |
| A | EP - A1 - 0 044 359 (7M COATINGS-ACADEMY OF APPLIED SCIENCE) * Claims; examples * | 1,4,5 | |
| A | EP - A1 - 0 206 170 (BRIDGETON CORPORATION) * Claim 1 * | 1 | |

TECHNICAL FIELDS
SEARCHED (Int. Cl.5)

C 09 J 167/00
C 09 J 163/00
C 09 J 133/00
C 08 L 67/00
C 08 L 63/00
C 08 L 33/00

The present search report has been drawn up for all claims

| Place of search | Date of completion of the search | Examiner |
|---|---|---|
| VIENNA | 17-10-1990 | PUSTERER |